# EUROPEAN PATENT SPECIFICATION

(11) **EP 1 630 728 B1**
(45) Date of publication and mention of the grant of the patent: **07.11.2007**
(21) Application number: 03733117.0
(22) Date of filing: 28.05.2003
(51) Int. Cl.: G06K 19/077

(54) **RADIO RECOGNITION SEMICONDUCTOR DEVICE AND ITS MANUFACTURING METHOD**
FUNKERKENNUNGSHALBLEITEREINRICHTUNG UND HERSTELLUNGSVERFAHREN DAFÜR
DISPOSITIF SEMI-CONDUCTEUR DE RADIO RECONNAISSANCE ET SON PROCEDE DE FABRICATION

(43) Date of publication of application: 01.03.2006
(73) Proprietor: Hitachi, Ltd., Tokyo 100-8280 (JP)
(72) Inventor: USAMI, Mitsuo c/o Central Research Laboratory, Kokubunji-shi, Tokyo 185-8601 (JP)
(74) Representative: Strehl, Peter
(86) International application number: PCT/JP2003/006660
(87) International publication number: WO 2004/107262

(56) References cited:
- DE-A1- 10 012 967
- DE-A1- 10 014 620
- JP-A- 2003 511 869

## Description

### TECHNICAL FIELD

The present invention relates to a technical field on a structure for fabricating a radio recognition semiconductor device at low cost.

### BACKGROUND ART

Documents to be referred to in this specification are as follows. The documents will be referred to by their document numbers.
[Document 1] JP-A-2000-76406
[Document 2] JP-A-2001-518220

Compared with barcodes, radio recognition semiconductors have a lot of advantages. However, there is a problem that the cost of the semiconductors itself and the cost for establishing connection with an antenna are high. Accordingly, the radio recognition semiconductors have not replaced the barcodes yet.

By increasing the number of chips that can be obtained from one wafer, the radio recognition semiconductors can be manufactured at low cost. Assume that one chip is of approximately 0. 05 mm squares, for example. Then, 28,000 thousand chips can be obtained from a 12-inch wafer. Accordingly, by reducing the size of the chip, the manufacturing cost can be reduced.

Further, in order to manufacture the radio recognition semiconductor at low cost, reduction of the cost for connecting the antenna to the minute chip obtained by reducing the chip size as described above may be considered. Picking minute chips one by one with vacuum tweezers and performing alignment and connection to small electrodes as in a conventional method will lead to a rise in the cost and reduction in production throughput due to a high device accuracy required. Since this method lacks mass productivity, an increase in the cost will be brought about.

As techniques related to this application, the following two techniques will be pointed out.

In document 1, there is disclosed the technique of forming a wire coil and connecting the wire coil to the semiconductor chip of a contactless IC card by a wire bonder.

In document 2, there is disclosed the technique in which wire bonding between bumps on a wafer by a wire is performed, the center of the wire is then cut, resulting wires are left on pads, and then the wires are used for connection between a chip and a package in a subsequent step.

DE 1 00 14 620 A1 discloses a method for manufacturing a carrier tape with a plurality of electrical units. The document has been used for the two-part form of present claim 1.

DE 1 00 12 967 A1 discloses a transponder in which a dipole antenna or a loop antenna is directly connected to the contact surfaces of a chip.

### DISCLOSURE OF THE INVENTION

The object of the present invention is to provide an improved device and method for the manufacturing of radio recognition semiconductor devices. Particularly, it is desired to provide antenna elements for the radio recognition semiconductor device which are readily connectable to the chip and have good communication performance.

The object is met by the device of present claim 1 and the method of claim 5. The dependent claims relate to preferred embodiments.

A typical example of the invention disclosed in this specification will be outlined as follows.

Connection between respective electrodes of radio recognition semiconductor chips separated to each other in a chain state is performed by wires, and the wires are cut into appropriate lengths, thereby functioning as antennas. With this arrangement, manufacture of the radio recognition semiconductor chips is facilitated.

### BRIEF DESCRIPTION OF THE DRAWINGS

Fig. 1 shows a basic wire connecting configuration;
Fig. 2 shows a basic wire cutting configuration;
Fig. 3 shows an embodiment of a wire loop according to the present invention;
Fig. 4 shows another embodiment of a wire loop according to the present invention;
Fig. 5 shows another embodiment of a wire loop according to the present invention;
Fig. 6 is a sectional view showing wire bonding on a wafer;
Fig. 7 shows another basic wire connecting configuration;
Fig. 8 shows another basic wire cutting configuration;
Fig. 9 shows an example of a wire configuration on a tape;
Fig. 10 shows another example of a wire configuration on the tape;
Fig. 11 shows another example of a wire configuration on the tape;
Fig. 12 shows an example of a planar configuration incorporated into paper;
Fig. 13 shows an example illustrating a configuration wound around a tape;
Fig. 14 shows an embodiment in which chips on a tape are wire bonded, according to the present invention;
Fig. 15 shows a configuration of a section incorporated into paper;
Fig. 16 shows a circuit configuration of a radio recognition semiconductor device;
Fig. 17 shows a chip with a wire antenna is embedded in paper;
Fig. 18 is a plan view of wire bonding on a wafer ; and
Fig. 19 shows inspecting a chip on a tape.

### BEST MODE FOR CARRYING OUT THE INVENTION

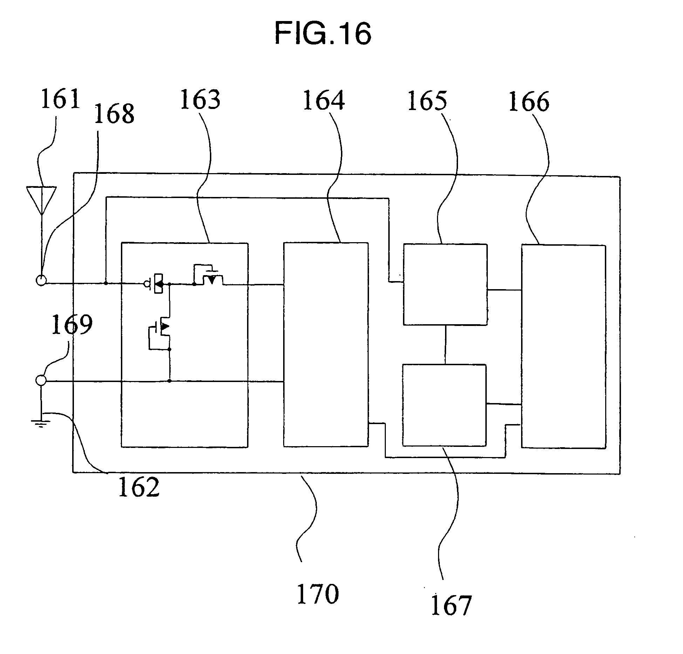

Fig. 16 shows a circuit configuration of a radio recognition semiconductor device. Reference numeral 170 denotes a semiconductor chip. An antenna 161 pairs up with a grounding point (antenna) 162. An electromagnetic wave input through electrodes 168 and 169 is rectified by a rectifying circuit 163, thereby generating a direct current voltage. This direct current voltage stores electric charges in a capacitor 164. A clock circuit 165 extracts a clock from a signal carried on the electromagnetic wave. A power-on reset circuit 167 sets an initial value of a memory circuit 166, upon receipt of the clock signal. The memory circuit is constituted from a counter, a decoder, memory cells having memory information, and a write circuit. These digital circuits operate in synchronization with the clock signal. The clock signal demodulates a signal obtained by modulation of the electromagnetic wave, for generation. Modulation methods include an AKF method that performs modulation with an amplitude, an FSK method that performs modulation with a frequency, and a PSK method that performs modulation with a phase. A method that combines these is also possible. The rectifying circuit is constituted from a capacitor, a diode, and the like, and converts an alternating waveform to a direct current waveform.

As typically shown in Fig. 16, the semiconductor chip of the present invention is constituted from a minimum of the two terminals (168, 169). When an electric wave is applied to an external antenna (161, 162), a high-speed alternating current flows. In order to cause this current to be flown inside the semiconductor chip, just the two terminals are required and sufficient as application of a voltage from the antenna. These two terminals are each constituted from the electrode of 30 to 50 micron squares, for example, which is referred to as a pad on the semiconductor chip. These pads are connected to the terminals of the antenna.

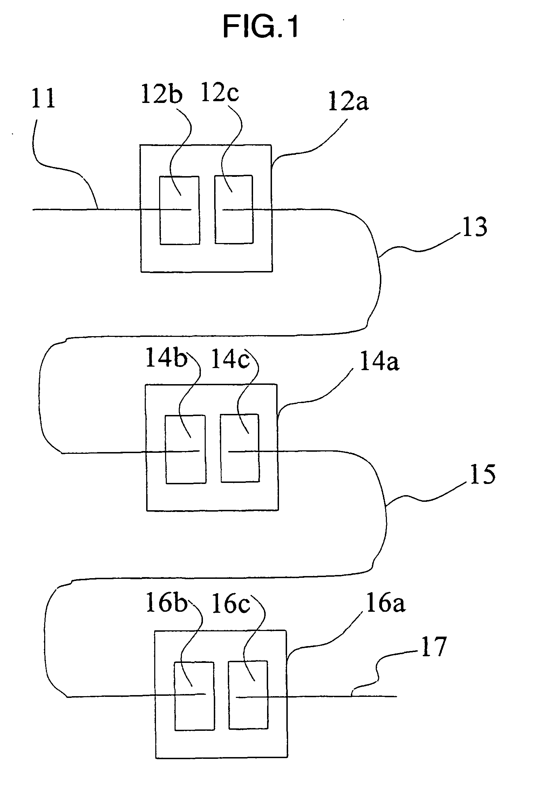

Fig. 1 shows a connecting configuration in which a first wire 11 is connected to a first semiconductor chip first electrode 12b of a first semiconductor chip 12a. A second wire 13 is connected to a first semiconductor chip second electrode 12c of the first semiconductor chip 12a. The second wire 13 is also connected to a second semiconductor chip first electrode 14b of a second semiconductor chip 14a. A third wire 15 is connected to a second semiconductor chip second electrode 14c of the second semiconductor chip 14a. The third wire 15 is also connected to a third semiconductor chip first electrode 16b of a third semiconductor chip 16a. A fourth wire 17 is connected to a third semiconductor chip second electrode 16c of the third semiconductor chip 16a. The electrodes 12b and 12c, 14b and 14c, and 16b and 16c in pairs corresponds to the electrodes 161 and 162 in Fig. 16, respectively.

By connecting the electrodes on the surface' of the chip in a chain form by wires, continuous connection of the wires that function as antennas can be continuously performed in a subsequent step. The step of fabrication will be described later in detail.

For connection of the electrodes to the wires, an existing machine such as a wire bonding device is used. As the material and size of the wires, aluminum, gold, or the like of 10 to 50 micron diameter can be used, for example, and connection to the electrodes of 30 to 50 micron squares can be thereby performed.

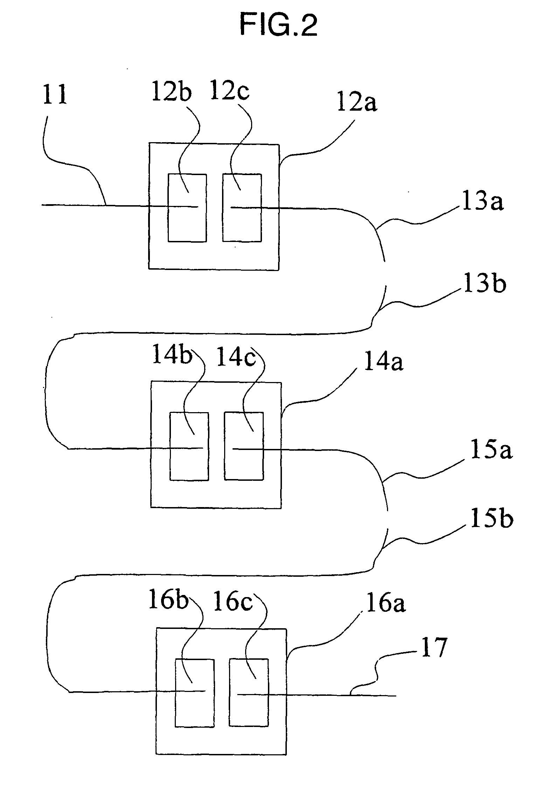

Fig. 2 shows a state in which in a configuration in Fig. 1, the second wire 13 is cut into a cut second wire 13a and another cut second wire 13b, and the third wire 15 is cut into a cut third wire 15a and another cut third wire 15b. Other configurations are the same as those in Fig. 1.

By cutting the wires (13, 15, and 17), the separated wires (13a, 13b, 15a, and 15b) will function as dipole antennas. In each of the semiconductor chips (12a, 14a, and 16a), the wires connected to the electrodes will function as the antenna, thereby enabling use as the radio recognition semiconductor device. The length of the cut wire can be determined by a required communication distance. Incidentally, the communication distance depends on power consumption of the semiconductor chip, and can be improved by the level of a technique to be used.

Further, by attaching the semiconductor chips 12a, 14a, 16a in Fig. 1 to a medium of a chip tape shape, convenience of handling can be improved.

It is described beforehand that as a pattern for electrode connection between the chips, various variations are assumed, and the connecting pattern is not limited to a specific arrangement shape.

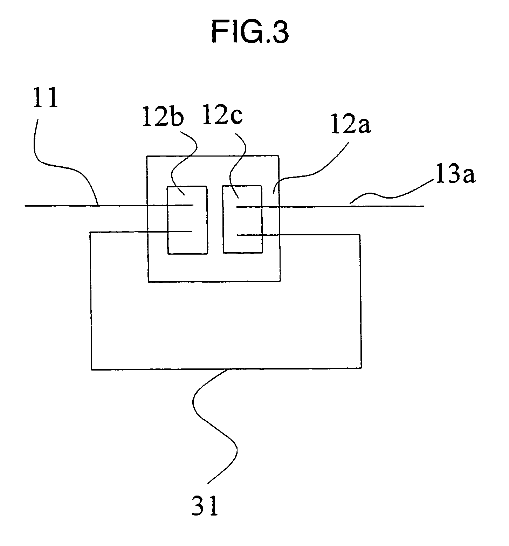

Fig. 3 shows a first embodiment of the present invention. There is shown a state in which the first wire 11 connected in the chain form is connected to the first semiconductor chip first electrode 12b of the first semiconductor chip 12a, the second wire 13 is connected to the first semiconductor chip second electrode 12c, and a loop wire 31 is connected to the first semiconductor chip first electrode 12b of the first semiconductor chip and the first semiconductor chip second electrode 12c of the first semiconductor chip. The electrodes 12b and 12c in the pair correspond to the electrodes 161 and 162 in Fig. 16, respectively.

The wires 11 and 13a constitute the antenna. By matching the input impedance of the semiconductor chip and the impedance of the antenna 11, 13a, the performance can be optimized. The loop wire 31 is effective as an inductance. By adjusting the shape of a loop, the optimum performance can be exhibited. The term "optimum" herein means maximization of the communication distance.

This loop wire 31 is fabricated by connecting a wire to the electrodes (12b and 12c, 14b and 14c, and 16b and 16c) on each of the semiconductor chips (12a, 14a, and 16a) in Fig. 1, connected in the chain form, in a loop form.

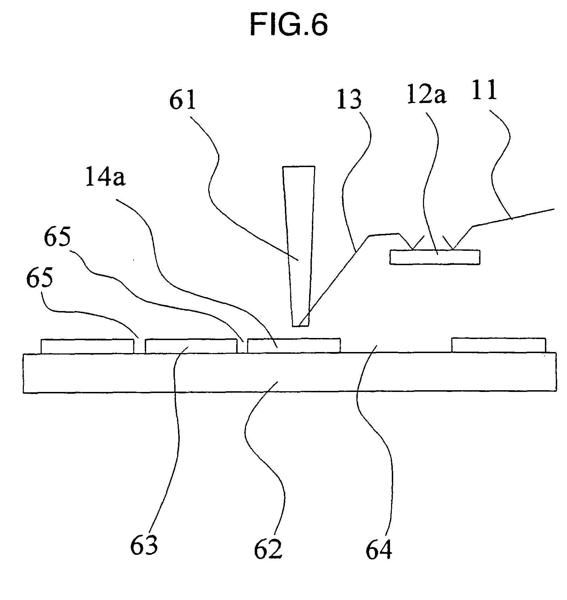

In this first embodiment, the size of the loop can be determined by securing the distance between the height of a wire bonder 61 in Fig. 6 and the semiconductor chip. Generally, this is the same as the operation of mounting the semiconductor chip on a semiconductor package and wire bonding the terminal of the semiconductor chip referred to as a bonding pad to the terminal of the semiconductor package referred to as a post at a one-to-one level. More specifically, since the distance between the bonding pad of each semiconductor chip and the post of the semiconductor package is different, the wire bonder first performs wire bonding on the bonding pad of the semiconductor chip and then adjusts the lifting height of the wire according to the value of the wire that has been programmed in advance. Then, the wire bonder carries out the operation of performing bonding to the post of the semiconductor package. When the loop according to the present invention is formed as well, the shape of the formed loop can be adjusted by the operation of adjusting the lifting height of the wire and performing bonding to a predetermined location. The optimum value of the loop shape can be determined by the input impedances at the two terminals of the semiconductor chip.

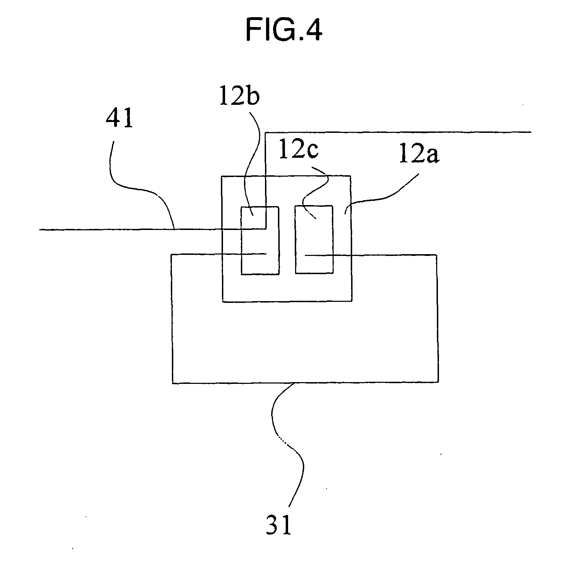

Fig. 4 shows a second embodiment. It is assumed that a continuous wire 41 is connected to the first semiconductor chip first electrode 12b of the first semiconductor chip 12a, and is further connected to the electrode of the next semiconductor chip without alteration. A state where the loop wire 31 is connected to the first semiconductor chip first electrode 12b and the first semiconductor chip second electrode 12c in this case is shown. The electrodes 12b and 12c in the pair correspond to the electrodes 161 and 162, respectively

In this second embodiment as well, the wire 41 is cut, thereby being functioned as the antennas. By matching the input impedance of the semiconductor chip 12a and the impedances of the antennas 41 and 31, the performance can be optimized.

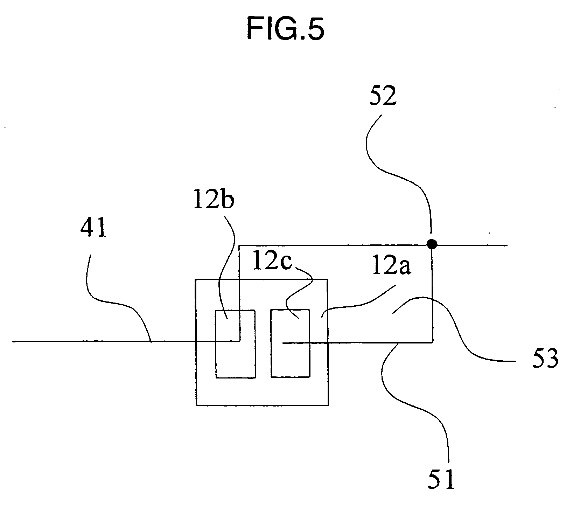

Fig. 5 shows a third embodiment. It is assumed in this drawing that the continuous wire 41 is connected to the first semiconductor chip first electrode 12b of the first semiconductor chip 12a, and is further connected to the electrode of the next semiconductor chip without alteration. In this case, a tap wire 51 is connected to the first semiconductor chip first electrode 12c. This wire is connected to a midpoint position 52 of the continuous wire 41. By connecting the wire 41 and a wire 51 connected to the different electrodes 12b and 12c of the semiconductor chip 12a respectively, a loop 53 is formed. The electrodes 12b and 12c in the pair corresponds to the electrodes 161 and 162 in Fig. 16, respectively. This loop 53 is effective as an inductance. By adjusting the shape of the loop, the optimum performance can be exhibited.

In the method of connecting the wire 51 to the wire 41, when the material of the wire is gold, the connection can be readily performed by thermo-pressure, and when the material of the wire is aluminum, the connection can be readily performed by ultrasonic vibration. For positioning when the wire 41 is connected to the wire 51, the connecting point there between is detected by an image processing technology, for example, and by moving the wire bonder 61 and a suction table 62 in Fig. 6 as necessary, attachment by pressure or ultrasonic vibration at the connecting point can be performed.

In the embodiments shown in Figs. 3, 4, and 5 described above, by measuring the input impedances at the two terminals of an internal circuit in the semiconductor chip in advance, and by adjusting the size of the loop antenna, the optimum performance can be exhibited.

While there are shown the embodiments in which the shape of the loop formed between the terminals 12b and 12c in Figs. 3, 4, and 5 is changed, the same effect can be obtained even if there is a change in the shape.

The size of the loop antenna can be freely set by adjusting the height of the wire bonder and changing the length of the wire in the first embodiment, using the method described before.

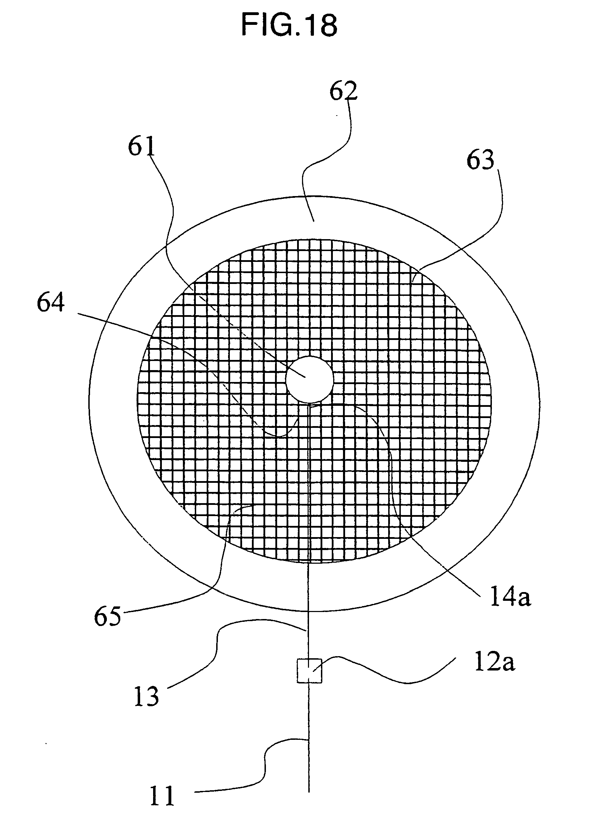

Fig. 6 shows a step of connecting a wire to an electrode on a semiconductor chip and a connecting device. Fig. 18 shows a plan view of Fig. 6. A wafer 63 is placed on a vacuum suction table after grooves for dicing have been formed in advance. For the dicing of the wafer, a dicing tape is attached to the underside of the thick wafer in advance, and the surface of the wafer is diced. Then, another tape is attached to the surface of the wafer, and the dicing tape on the underside is detached. The wafer is placed on the vacuum suction table in this state, for attachment. Then, when the tape on the surface is detached, a state shown in Fig. 6 is readily obtained.

As shown in Fig. 6, using the wire bonder 61, wire bonding is performed on each of the semiconductor chips (12a, 14a) on the wafer 63 on the vacuum suction table 62, in which dicing grooves 65 have been formed in advance. The first wire 11 is connected to the first semiconductor chip 12a. The second wire 13 is connected to the first semiconductor chip 12a and is then connected to the second semiconductor chip 14a on the subsequent wafer. A portion 64 of the wafer from which the first semiconductor chip has been picked up appears when the first semiconductor is connected in the chain form by the wire. As shown in this drawing, by the wire bonder, the semiconductor chips are connected by the wires, one after another. With this arrangement, wire bonding can be directly performed on the wafer, without handling the semiconductor chips one by one.

As described in the third embodiment as well, in regard to positioning of the connecting point between a wire and a pad, the connecting point is detected by the image processing technology, for example, and by moving the wire bonder or the suction table as necessary, the position of the connecting point is determined. Then, by performing attachment by pressure or ultrasonic vibration at the pad connecting point, bonding connection becomes possible.

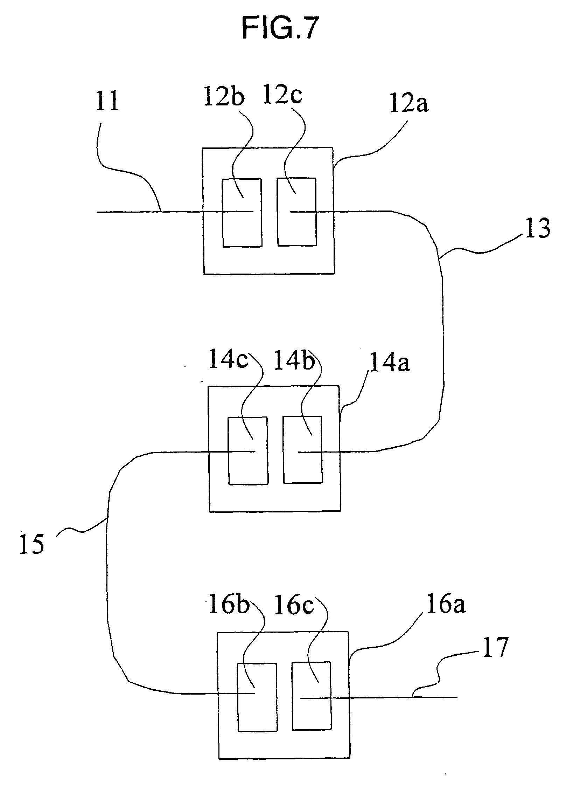

Fig. 7 shows a connection configuration in which the first wire 11 is connected to the first semiconductor chip first electrode 12b of the first semiconductor chip 12a. The second wire 13 is connected to the first semiconductor chip second electrode 12c of the first semiconductor chip 12a. The second wire 13 is also connected to the second semiconductor chip first electrode 14b of the second semiconductor chip 14a. The third wire 15 is connected to the second semiconductor chip second electrode 14c of the second semiconductor chip 14a. The third wire 15 is also connected to the third semiconductor chip first electrode 16b of the third semiconductor chip 16a. The fourth wire 17 is connected to the third semiconductor chip second electrode 16c of the third semiconductor chip 16a. The configuration in Fig. 7 is different from the configuration in Fig. 1 in that wire bonding is performed on the pads of the adjacent semiconductor chips that are close to each other. With this arrangement, the moving distance of the wire bonder 61 is reduced, so that the time required for the step of wire bonding can be reduced.

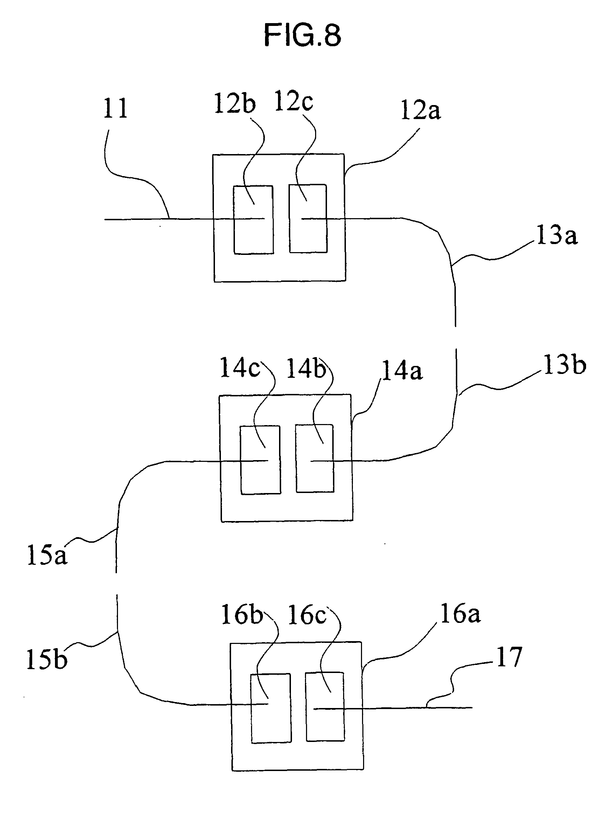

Fig. 8 shows a state in which the second wire 13 is cut into the cut second wire 13a and the another cut second wire 13b, and the third wire 15 is cut into the cut third wire 15a and the another cut third wire 15b in a configuration in Fig. 7. Other configurations are the same as those in Fig. 7. As described in the configuration shown in Fig. 2, by cutting the wires 13 and 15 for separation, they will function as individual radio recognition semiconductor devices.

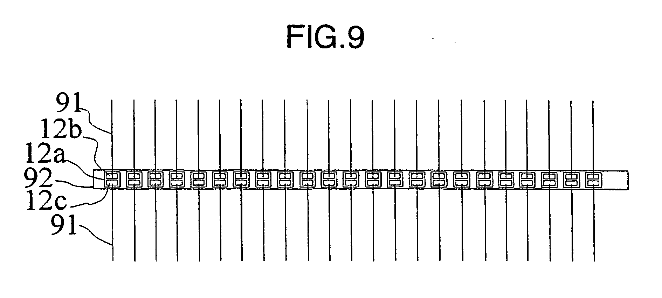

Fig. 9 shows an arrangement in which the semiconductor chip 12a is mounted on or attached to a carrier tape. A wire 91 is connected to the electrodes 12b and 12c of the semiconductor chip 12a. The semiconductor chips are continuously mounted on the carrier tape.

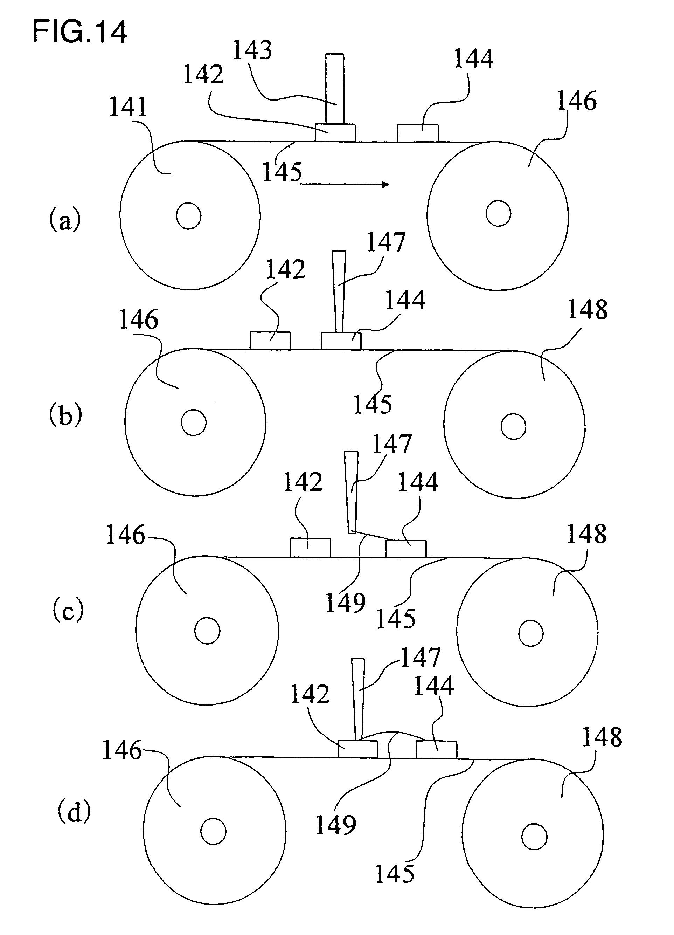

Fig. 9 shows a first connecting relationship between the radio recognition semiconductor chips 12a mounted on the carrier tape and the wire 91. The first connecting relationship is implemented by a connecting device in Fig. 14. The connecting device in Fig. 14 will be described later in detail. After the semiconductor chips have been attached to a carrier tape 92 (145 in Fig. 14) and then a wire bonder 147 has bonded the wire 91 (149 in Fig. 14) to the pads 12b and 12c of the semiconductor chip 12a, the wire bonder 147 or the carrier tape 145 is moved to stretch the wire, for cutting. The connecting relationship shown in Fig. 9 can be thereby obtained.

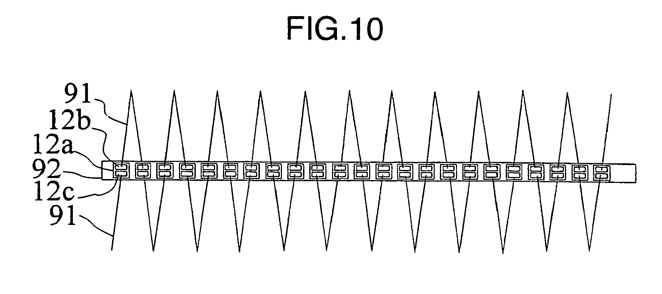

Fig. 10 shows a second connecting relationship between the radio recognition semiconductor chips 12a mounted on the carrier tape and the wire 91. The second connecting relationship in Fig. 10 is implemented by the connecting device in Fig. 14. The wire 91 connects the electrodes of the adjacent semiconductor chips 12a in a semi-loop state. After the semiconductor chips 12a have been attached to the carrier tape 92 (145 in Fig. 14) and then the wire bonder 147 has bonded the wire 91 to the pads 12b and 12c of the semiconductor chip, the wire bonder or the tape is moved to stretch the wire. Then, by performing moving control so that the wire is bent, the connecting relationship in Fig. 10 can be obtained.

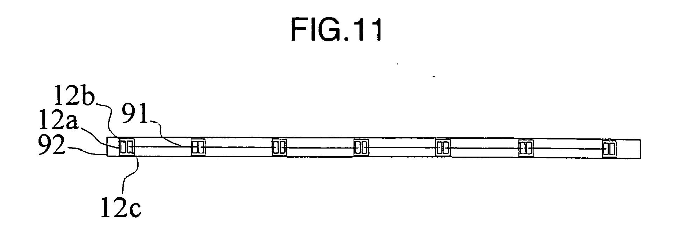

Fig. 11 shows a third connecting relationship between the radio recognition semiconductor chips 12a mounted on the carrier tape and the wire 91. The third connecting relationship in Fig. 11 is implemented by the connecting device in Fig. 14. The wire 91 linearly connects the electrodes of the semiconductor chips adjacent to each other. After the semiconductor chip 12a has been attached to the carrier tape 92 (145 in Fig. 14) and then the wire bonder 147 has bonded the wire 91 to the pads 12b and 12c of the semiconductor chip, the wire bonder or the tape is moved to stretch the wire. Then, by performing moving control, the connecting relationship in Fig. 11 can be obtained. The connecting relationship in which the chips are connected on a line in the chain form as in Fig. 11 can perform the connection at high speed.

Figs. 9, 10, and 11 are all characterized by mounting the semiconductor chips on the tape carrier in advance. By mounting the semiconductor chips on the carrier tape, antennas can be formed in volume and economically. Further, if this step is executed in parallel, mass productivity can be further improved.

Alternatively, by attaching the wire 91 to the carrier tape 92, the wire may be protected.

Alternatively, when the.semiconductor chip 12a with a wire antenna connected thereto is embedded in paper, the semiconductor chip 12a can be embedded in the paper or the like by a paper-making process or the like when the tape carrier is formed of a material that is soluble in water. As the material soluble in water, a starch molecule structure in a fiber state can be pointed out.

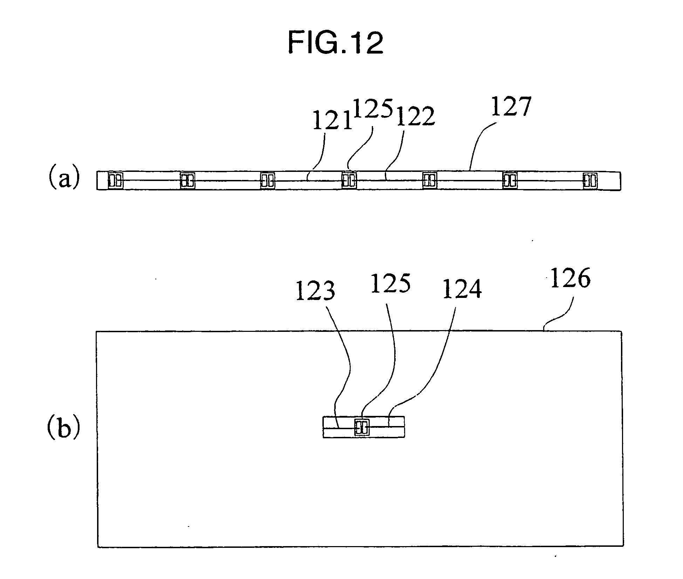

Fig. 12(a) shows a state in which a first wire 121 and a second wire 122 are connected to a semiconductor chip 125, and each of the first wire 121 and the second wire 122 is mounted on a carrier tape 127. Fig. 12(b) shows a state in which this carrier tape 127 is cut, and a cut first wire 123 and a cut second wire are connected to the semiconductor chip 125, on a paper medium (such as a negotiable paper) 126. The carrier tape is cut and then mounted on the negotiable paper, or partially attached to the negotiable paper and then cut. An approach to attaching an ordinary tape to the paper medium and then cutting the tape can be adopted. Further, by using a material that is soluble in water or other solvent for the carrier tape, the thickness of the carrier tape can also be reduced. Further, by attaching the wire to the carrier tape in advance, the wire can be prevented from being separated from the carrier tape, and the shape of the device can be prevented from being unstable after the carrier tape has been cut.

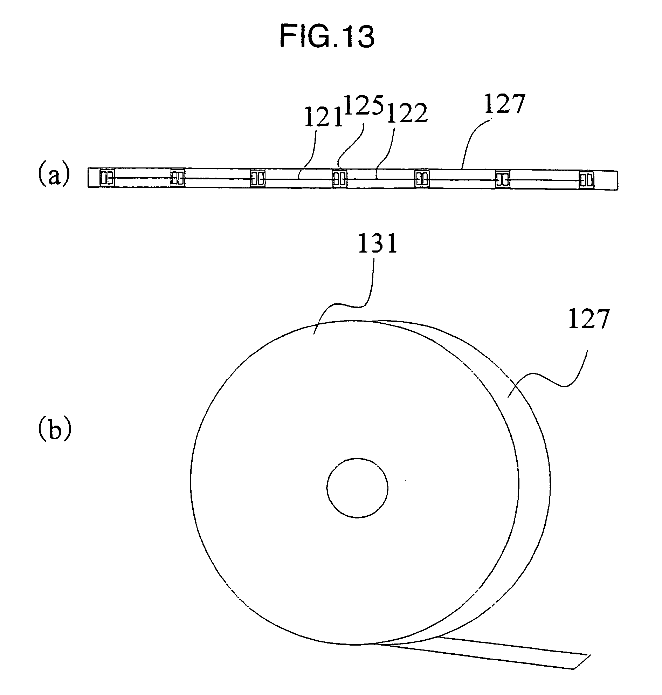

Fig. 13(a) shows a state in which the first wire 121 and the second wire 122 are connected to the semiconductor chips 125, and each of the first wire 121 and the second wire 122 is mounted on the carrier tape 127. A wound carrier tape 131 in Fig. 13(b) shows a state where the carrier tape 127 with a lot of the semiconductor chips 125 and the wires 122 mounted thereon is wound.

Since the radio recognition semiconductor device is attached to various media, there are various final forms of the device. The devices in Figs. 1 to 5 and Figs. 6 to 11 are also used as intermediates of the semiconductor device, which show the devices in a state in which the antennas are bonded to the semiconductor chips, for supply. Technically, they are referred to as inlets.

By reducing the size of the chip indicated by the chips 12a, 14a, 16a, or the like, mechanical strength against bending and physical shock can be strengthened. By providing each electrode for respective both sides, and by utilizing all the surface areas of the front and back surfaces, a large electrode can be formed. Further, by making the thickness of the electrodes thick, the mechanical strength can be further strengthened. With respect to the thickness of the chips, a radio recognition semiconductor with an antenna with the thickness of the chip therein thinned to the limit can be employed. When the thickness of the semiconductor chip is set to 10 microns and the thickness of the conductor of the antenna is set to 10 microns, the thickness of the semiconductor chip of 10 microns is combined with the thickness of the antenna on the upper surface, thereby totaling to the thickness of 20 microns. When this thickness is used and the thickness mounted on the paper medium at the time of completion is 100 microns, the completion with the sufficiently flat state of the device is facilitated.

Sectional views of steps for connecting a wire to electrodes on a semiconductor chip and the connecting device will be shown in Figs. 14(a) to 14(d).

Fig. 14(a) shows a step in which a carrier tape 145 is pulled out from a reeled carrier tape with no chips 141 and a first semiconductor chip 144 and a second semiconductor chip 142 are mounted on the carrier tape 141 with tweezers 143. After attachment of the semiconductor chip 144, movement is made to identify the location of the chip using image processing or the like. Then, one or both of the tweezers 143 and the carrier tape 144 are moved for alignment, and mounting is performed. The carrier tape 141 is wound around a reeled tape with chips 146.

Fig. 14(b) shows a step immediately after the reeled carrier tape with chips 146 shown in Fig. 14(a) has been set for the wire bonding device to pull out the carrier tape 145, and then bonding has been performed on the electrodes of the first semiconductor chip 144 by the bonding head 147.

Fig. 14(c) shows a state in which the carrier tape 145 is being moved to the chips 142 and 144, and a wire 149 is being stretched, after the step in Fig. 14(b).

Fig. 14(d) shows a sectional view in which the carrier tape has been further moved and then the second semiconductor chip 142 is placed immediately below the bonding head for bonding, after the step of Fig. 14(c). Fig. 14(d) shows a step in which the carrier tape 145 is wound as a tape with wire bonding finished thereon 148.

By passing through the steps 14(a) to 14(d) described above, the connecting relationships between the electrodes on the semiconductor device and the wire(s), as shown in the description above can be established.

In Fig. 14(d), the case when the wire 149 is not attached to the carrier tape was shown. The wire may be attached to the carrier tape through scanning by the bonding head 147.

Further, since the carrier tape is moved for bonding, a high-speed and simple device configuration can be made.

The materials of the electrodes of the semiconductor chips and the wire are not particularly specified. However, when the electrodes are formed of gold and the wire is made of gold, the gold is more advantageous over other selected materials in connectivity and corrosion resistance. Accordingly, this enables the device to have excellent reliability in a step involving use of moisture such as paper or in a use-condition environment. Further, when gold wires are connected, connection is easy, so that the gold is suitable for formation of the loop shape shown in the present invention. The connecting relationships that can be established in the steps in Fig. 14 are those of Figs. 1, 3, 4, 5, 7, 9, 10, and 11.

When the positions of the wire bonder and the tape are determined by image processing or the like and the positions of the wire(s) and the pads are aligned, arbitrary connection is basically possible. However, in the connecting relationship in which the connection is made on the line in the chain form as that in Fig. 11, high-speed connection can be made.

In the case of the minute chip of 100 micron squares, 50 micron squares, or 10 micron squares, good handling ability is provided because wire-bonded semiconductor chips are mounted on the carrier tape. Accordingly, the device can be applied to various applications irrespective of the size of the semiconductor chips.

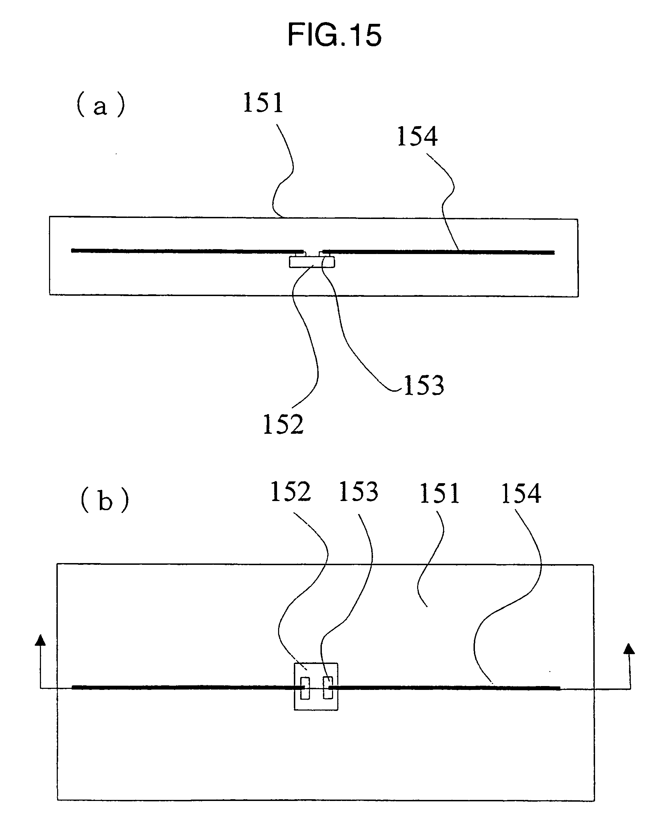

Fig. 15 (a) shows a sectional view of a paper medium 151. An electrode 153 is placed on a semiconductor chip 152 and is connected to a wire 154. For the paper medium, the method of providing strong strength with respect to bending of the medium is necessary. Herein, it is shown that the connecting position between the wire and the electrode is placed on the neutral surface of the section of the paper medium so that when the paper is bent, disconnection does not occur due to stretching of the wire. When a film-like medium is bent, the surface of the medium becomes a convex surface or a concave surface. When the section of the bent medium on the sectional view is looked over, there is a portion that is not extended or contracted in the vicinity of the inner center of the medium from the surface of the medium. This portion is herein referred to as the neutral surface. When the surface of the medium is the convex surface, an extension occurs on the surface of the medium. When the surface of the medium is the concave surface, a contraction occurs on the surface of the medium. Fig. 15(b) shows a plan view of the semiconductor chip and the antenna corresponding to those in Fig. 15(a).

The antenna of the wire antenna is thin. Thus, when a plurality of radio recognition semiconductor devices are attached to various media, a probability that the antennas will be overlapped is low. Thus, the wire antenna is excellent in interference resistance between the antennas. The wire antenna thus has a preferable feature for the radio recognition semiconductor device equipped with an anti-collision control function.

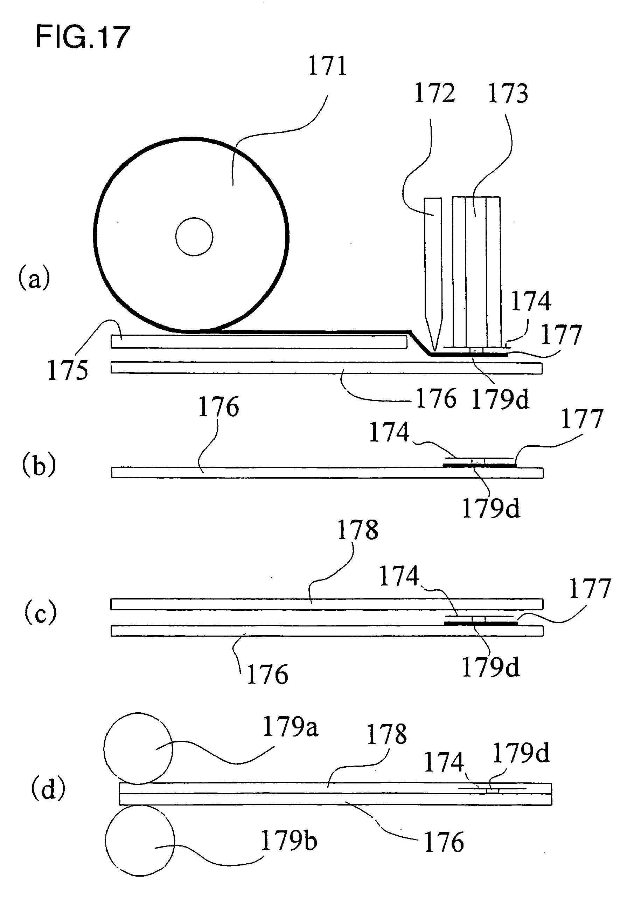

Fig. 17(a) to 17(d) show a method in which a radio semiconductor chip with a wire is mounted on a paper-like medium and a sectional view of a mounting device.

Fig. 17(a) shows a state in which when a carrier tape 177 with a radio semiconductor chip 179d including a wire antenna 174 mounted thereon is pulled out from a reel 171 along a guide 175 by a suction device 173, moved, and positioned at a predetermined location, the carrier tape is cut by a cutter 172, and arranged onto a gel-like pulp including a large amount of moisture.

Fig. 17(b) is a step next to the one shown in Fig. 17(a), and shows a state in which the cut carrier tape 177, semiconductor chip 179, and connected wire antenna 174 are arranged on the gel-like pulp 176.

Fig. 17(c) is a step next to the one shown in Fig. 17(b) and shows a state in which with a gel-like pulp 178 including a large amount of moisture, the cut carrier tape 177, semiconductor chip 179d, and connected wire antenna 174 are covered. By this step, the semiconductor chip 179d, wire antenna, and carrier tape 177 are sandwiched between the gel-like pulps 176 and 178.

Fig. 17(d) is a step next to the one shown in Fig. 17(c) and shows a state in which calendar processing of compressing the gel-like pulps with the large amount of moisture, getting rid of the moisture, and planarizing the surfaces of the pulps is performed by metal rollers 179a and 179b. This carrier tape 174 may be formed of a material that is soluble in water. The last step shows a state in which the tape has been solved and has disappeared. By the steps described above, the semiconductor chip 179d can be embedded in the paper medium such as the negotiable paper. Banknotes are often made using the paper-making process, so that the radio recognition semiconductor can be embedded under a condition in which thin, flat paper is made. When the device is of a structure having a sufficiently large mechanical strength, moisture can also be gotten rid of by the calendar processing or the like. The negotiable paper of a thickness from 100 microns to 200 microns is often used. When the thickness of the radio recognition semiconductor chip is set to the thickness of the paper medium or less such as 100 microns or less, the chip can be made flat without forming a protrusion even when the chip is mounted on the paper medium or the like. The radio recognition semiconductor chip can also be attached to the paper or included in the paper having a recessed portion.

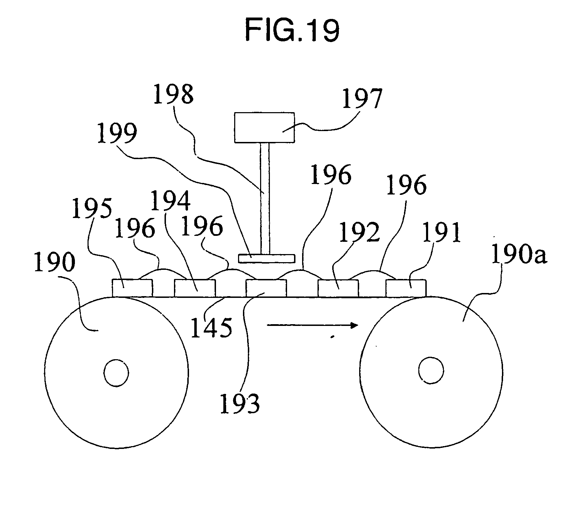

This Fig. 19 shows a method of inspecting the semiconductor chips connected to one after another (in the chain state) by the wire. The carrier tape 145 is pulled out from a reeled carrier tape 190, and a first semiconductor chip 191, a second semiconductor chip 192, a third semiconductor chip 193, a fourth semiconductor chip 194, and a fifth semiconductor chip 195 are mounted are mounted on the carrier tape 145. These semiconductor chips are mutually connected by a wire 196. On the reeled carrier tape 190, a relationship between these semiconductor chips and the wire, or a state where the semiconductor chips are connected to the wire one after another is present repeatedly. A reader 197 is connected to an antenna head 199 by a coaxial cable 198. The antenna head is brought close to one of the semiconductor chips. An electromagnetic field is generated by a signal from the reader, and the reader receives a response signal from the semiconductor chip through the wire. When this signal is normal, the reader determines that the semiconductor chip is a conforming item. When the signal is abnormal, the reader determines that the semiconductor chip is a defective item. When an inspection on one of the semiconductor chips is finished, the carrier tape is moved by a transfer mechanism, and places the next semiconductor chip immediately below the antenna head 199. Then, the inspection is carried out by the method that is the same as the method described before. The carrier tape is wound around the reeled tape 146 in succession. Since the inspection is continuously carried out on the semiconductor chips mounted on the carrier tape, a feature of eliminating the need for deploying a complicated mechanism can be obtained. This brings about simplification and higher speed of the semiconductor chip inspection, and accelerates economical preparation of the semiconductor device including the wire according to the present invention.

### INDUSTRIAL APPLICABILITY

The invention in the present application is used for manufacturing the radio recognition semiconductor device.

## Claims

1. A device comprising
a plurality of radio recognition semiconductor chips (12a, 14a, 16a; 142, 144; 152; 170; 179d; 191 to 195) separated from each other and each including at least two electrodes (12b, 12c; 14b, 14c; 16b, 16c; 153; 168, 169), and
wires (11, 13, 15, 17; 41, 51; 91; 121 to 124; 149; 154; 174; 196) for connecting the electrodes so that any one of the chips is connected to at least one of the other chips through one of the wires,
**characterised in that**
the wires are suitable to form antennas (13a, 13b; 15a, 15b; 154; 161, 162; 174) after having been cut so that the connection to said at least one of the other chips is interrupted, and
a loop antenna (31; 53) arranged for matching the antenna impedance to the input impedance of the semiconductor chip is formed in addition by at least one of the wires which is connected to two of the electrodes located on the same chip (12a).

2. The device of claim 1, wherein the loop antenna (53) comprises a plurality of the wires (41, 51).

3. The device of claim 1, wherein the chips are mounted on a tape-like medium (92; 127; 145; 177).

4. The device of claim 3, wherein the tape-like medium (92; 127; 145; 177) is made of a material soluble in a liquid.

5. A method of manufacturing a radio recognition semiconductor device, comprising the following steps:
providing a plurality of separated radio recognition semiconductor chips (12a, 14a, 16a; 142, 144; 152; 170; 179d; 191 to 195) each including at least two electrodes (12b, 12c; 14b, 14c; 16b, 16c; 153; 168, 169);
connecting a first electrode (14b) of a first one of the chips (14a) to one of the electrodes (12c) of a second one of the chips (12a) by a first wire (13; 41) suitable for forming an antenna when cut for interrupting the connection between the first and second chips;
connecting the first electrode (14b) or a second electrode (14c) of said first chip (14a) to one of the electrodes (16b) of a third one of the chips (16a) by said wire (41) or by a second wire (15) suitable for forming an antenna with said first wire (13) when cut for interrupting the connection between the first and third chips;
repeating the above connecting steps to perform the coupling between the respective electrodes of the chips; and
adapting the antenna impedance to the input impedance of the corresponding semiconductor chip by forming a loop antenna (31; 53) connecting two electrodes (12b, 12c) located on the same chip (12a) by another wire (31; 51).

6. The method of claim 5, further comprising the step of mounting the chips (12a, 14a, 16a; 142, 144; 152; 170; 179d; 191 to 195) on a tape-like medium (92; 127; 145; 177).

7. The method of claim 5 or 6, further comprising the step of cutting the wires (11, 13, 15, 17; 41; 91; 121, 122; 149; 196) interconnecting the chips to obtain separated radio recognition semiconductor devices, wherein the cut wires (13a, 13b; 15a, 15b; 123, 124; 154; 174) form antennas (161, 162).

## Patentansprüche

1. Vorrichtung mit
mehreren Funkerkennungs-Halbleiterchips (12a, 14a, 16a; 142, 144; 152; 170; 179d; 191 bis 195), die voneinander getrennt sind und jeweils wenigstens zwei Elektroden (12b, 12c; 14b, 14c; 16b,- 16c; 153; 168, 169) aufweisen, und
Drähten (11, 13, 15, 17; 41, 51; 91; 121 bis 124; 149; 154; 174; 196) zum Verbinden der Elektroden, so dass jeder der Chips durch einen der Drähte mit wenigstens einem der anderen Chips verbunden ist,
**dadurch gekennzeichnet, dass**
die Drähte dazu geeignet sind, Antennen (13a, 13b; 15a, 15b; 154; 161, 162; 174) zu bilden, nachdem sie durchgeschnitten wurden, so dass die Verbindung zu dem wenigstens einen der anderen Chips unterbrochen ist, und
eine Ringantenne (31; 53) zusätzlich durch wenigstens einen der Drähte gebildet ist, der an zwei der Elektroden auf dem gleichen Chip (12a) angeschlossen ist, wobei die Ringantenne dazu ausgelegt ist, die Antennenimpedanz an die Eingangsimpedanz des Halbleiterchips anzupassen.

2. Vorrichtung nach Anspruch 1, wobei die Ringantenne (53) mehrere der Drähte (41, 51) aufweist.

3. Vorrichtung nach Anspruch 1, wobei die Chips auf einem bandartigen Medium (92; 127; 145; 177) befestigt sind.

4. Vorrichtung nach Anspruch 3, wobei das bandartige Medium (92; 127; 145; 177) aus einem flüssigkeitslöslichen Material hergestellt ist.

5. Verfahren zum Herstellen einer Funkerkennungs-Halbleitervorrichtung, wobei
mehrere getrennte Funkerkennungs-Halbleiterchips (12a, 14a, 16a; 142, 144; 152; 170; 179d; 191 bis 195), die jeweils wenigstens zwei Elektroden (12b, 12c; 14b, 14c; 16b, 16c; 153; 168, 169) aufweisen, bereitgestellt werden;
eine erste Elektrode (14b) von einem ersten der Chips (14a) an eine der Elektroden (12c) eines zweiten der Chips (12a) durch einen ersten Draht (13; 41) angeschlossen wird, der dazu geeignet ist, eine Antenne zu bilden, wenn er zum Unterbrechen der Verbindung zwischen dem ersten und dem zweiten Chip durchgeschnitten ist;
die erste Elektrode (14b) oder eine zweite Elektrode (14c) des ersten Chips (14a) durch den Draht (41) oder durch einen zweiten Draht (15) an eine der Elektroden (16b) eines dritten der Chips (16a) angeschlossen wird, der dazu geeignet ist, mit dem ersten Draht (13) eine Antenne zu bilden, wenn er zum Unterbrechen der Verbindung zwischen dem ersten und dem dritten Chip durchgeschnitten wird;
die oben angegebenen Verbindungsvorgänge wiederholt werden, um die Kopplung zwischen den jeweiligen Elektroden der Chips durchzuführen; und
die Antennenimpedanz an die Eingangsimpedanz des entsprechenden Halbleiterchips angepasst wird, indem eine Ringantenne (31; 53) gebildet wird, die zwei Elektroden (12b, 12c) auf dem gleichen Chip (12a) durch einen anderen Draht (31; 51) miteinander verbindet.

6. Verfahren nach Anspruch 5, wobei die Chips (12a, 14a, 16a; 142, 144; 152; 170; 179d; 191 bis 195) ferner auf einem bandartigen Medium (92; 127; 145; 177) befestigt werden.

7. Verfahren nach Anspruch 5 oder 6, wobei ferner die Drähte (11, 13, 15, 17; 41; 91; 121, 122; 149; 196), die die Chips miteinander verbinden, durchgeschnitten werden, um getrennte Funkerkennungs-Halbleitervorrichtungen zu erhalten, wobei die durchgeschnittenen Drähte (13a, 13b; 15a, 15b; 123, 124; 154; 174) Antennen (161, 162) bilden.

## Revendications

1. Dispositif comportant :
une pluralité de puces semi-conductrices de radio reconnaissance (12a, 14a, 16a ; 142, 144 ; 152 ; 170 ; 179d ; 191 à 195) séparées les unes des autres et incluant chacune au moins deux électrodes (12b, 12c ; 14b, 14c ; 16b, 16c ; 153 ; 168, 169), et
des fils (11, 13, 15, 17 ; 41, 51 ; 91 ; 121 à 124 ; 149 ; 154 ; 174 ; 196) pour connecter les électrodes de sorte que l'une quelconque des puces est connectée à au moins une des autres puces par l'intermédiaire d'un des fils,
**caractérisé en ce que**
les fils sont adaptés pour former des antennes (13a, 13b ; 15a, 15b ; 154 ; 161, 162 ; 174) après avoir été découpées de sorte que la connexion à ladite au moins une des autres puces est interrompue, et
une antenne cadre (31 ; 53) conçue pour faire correspondre l'impédance d'antenne à l'impédance d'entrée de la puce semi-conductrice est formée de plus par au moins un des fils qui est connecté à deux des électrodes situées sur la même puce (12a).

2. Dispositif selon la revendication 1, dans lequel l'antenne cadre (53) comporte une pluralité des fils (41, 51).

3. Dispositif selon la revendication 1, dans lequel les puces sont montées sur un support de type bande (92 ; 127 ; 145 ; 177).

4. Dispositif selon la revendication 3, dans lequel le support de type bande (92 ; 127 ; 145 ; 177) est constitué d'un matériau soluble dans un liquide.

5. Procédé de fabrication d'un dispositif à semi-conducteurs de radio reconnaissance, comportant les étapes suivantes consistant à :
fournir une pluralité de puces semi-conductrices de radio reconnaissance séparées (12a, 14a, 16a ; 142, 144 ; 152 ; 170 ; 179d ; 191 à 195) incluant chacune au moins deux électrodes (12b, 12c ; 14b, 14c ; 16b, 16c ; 153 ; 168, 169),
connecter une première électrode (14b) d'une première des puces (14a) à une des électrodes (12c) d'une deuxième des puces (12a) à l'aide d'un premier fil (13 ; 41) adapté pour former une antenne lorsque coupé pour interrompre la connexion entre les première et deuxième puces,
connecter la première électrode (14b) ou une seconde électrode (14c) de ladite première puce (14a) à une des électrodes (16b) d'une troisième des puces (16a) à l'aide dudit fil (41) ou d'un second fil (15) adapté pur former une antenne avec ledit premier fil (13) lorsque coupé pour interrompre la connexion entre les première et troisième puces,
répéter les étapes de connexion ci-dessus pour effectuer le couplage entre les électrodes respectives des puces, et
adapter l'impédance d'antenne à l'impédance d'entrée de la puce semi-conductrice correspondante en formant une antenne cadre (31 ; 53) connectant deux électrodes (12b, 12c) situées sur la même puce (12a) à l'aide d'un autre fil (31 ; 51).

6. Procédé selon la revendication 5, comportant de plus l'étape consistant à monter les puces (12a, 14a, 16a ; 142, 144 ; 152 ; 170 ; 179d ; 191 à 195) sur un support de type bande (92 ; 127 ; 145 ; 177).

7. Procédé selon la revendication 5 ou 6, comportant de plus l'étape consistant à couper les fils (11, 13, 15, 17 ; 41 ; 91 ; 121, 122 ; 149 ; 196) interconnectant les puces pour obtenir des dispositifs à semi-conducteurs de radio reconnaissance séparés, dans lesquels les fils coupés (13a, 13b ; 15a, 15b ; 123, 124 ; 154 ; 174) forment des antennes (161, 162).
